(19) Europäisches Patentamt
European Patent Office
Office européen des brevets

(11) **EP 2 789 051 B1**

(12) **FASCICULE DE BREVET EUROPEEN**

(45) Date de publication et mention
de la délivrance du brevet:
**25.11.2020 Bulletin 2020/48**

(21) Numéro de dépôt: **12795437.8**

(22) Date de dépôt: **04.12.2012**

(51) Int Cl.:
*H01Q 15/14* (2006.01)          *E04F 13/12* (2006.01)
*H01Q 1/52* (2006.01)          *H05K 9/00* (2006.01)
*E04F 13/08* (2006.01)

(86) Numéro de dépôt international:
**PCT/EP2012/074382**

(87) Numéro de publication internationale:
**WO 2013/083572 (13.06.2013 Gazette 2013/24)**

(54) **Utilisation d'un dispositif diffracteur**

Benutzung einer entspiegelnden Vorrichtung

Use of a diffracting device

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **06.12.2011 FR 1161242**

(43) Date de publication de la demande:
**15.10.2014 Bulletin 2014/42**

(73) Titulaire: **AIRBUS (SAS)**
**31700 Blagnac (FR)**

(72) Inventeurs:
• **THAIN, Andrew**
**F-32600 L'Isle Jourdain (FR)**
• **PERES, Gilles**
**F-31000 Toulouse (FR)**

(74) Mandataire: **Gicquel, Olivier Yves Gérard et al**
**Airbus Opérations (S.A.S)**
**XIF - M0101/1**
**316, route de Bayonne**
**31060 Toulouse Cedex (FR)**

(56) Documents cités:
**DE-A1-102008 059 018     JP-A- 2011 109 414
US-A- 3 538 663     US-A- 5 057 842**

**Description**

L'invention se rapporte au domaine général de la réflexion des ondes électromagnétiques, des ondes radio en particulier, et plus particulièrement à celui de la prévention des effets des ondes radioélectriques réfléchies par des structures telle des façades de bâtiments sur l'espace environnant de telles structures. On s'intéresse en particulier aux effets des ondes radio réfléchies par des bâtiments situés en zone aéroportuaire sur le bon fonctionnement de systèmes de mesures radioélectriques.

Quand on s'intéresse à l'aménagement de zones aéroportuaires, un problème important consiste à déterminer la meilleure manière d'implanter les bâtiments nécessaires au fonctionnement des services de l'aéroport pour limiter au minimum les effets indirects de cette implantation sur les zones sensibles d'un point de vue radioélectrique. En effet, de telles structures présentent généralement des façades de grandes dimensions, façades qui se comportent comme des réflecteurs des ondes radioélectriques émises par les différentes sources d'émissions présentes au voisinage ou à l'intérieur de la zone de l'aéroport. Or il est des cas où la réflexion par la façade d'un bâtiment de l'émission radioélectrique produite par une source, distante ou non du bâtiment peut s'avérer extrêmement gênante dans la mesure où le signal reçu par la façade est réfléchi vers une zone où il vient polluer les émissions radioélectriques réalisées dans cette zone. C'est en particulier le cas si un bâtiment situé dans une zone relativement proche d'une piste d'atterrissage réfléchit en direction de la piste une émission radioélectrique dont la bande de fréquence se situe dans la bande occupée par les émissions du système d'atterrissage ILS, dans la bande occupée par le "Localiser" (radioalignement sur l'axe de piste) en particulier. Une telle réflexion parasite, si elle est assez forte, peut venir altérer le signal localiseur et par suite perturber l'alignement sur l'axe de la piste des aéronefs en phase d'atterrissage.

A cause de la présence des nombreuses sources radioélectriques, notamment les antennes ILS elles mêmes, le problème des réflexions parasites par les bâtiments est un problème important dont la résolution passe généralement par l'élaboration d'un plan d'implantation comportant des zones, notamment les zones relativement proches des pistes où l'on s'interdit de placer une quelconque construction de taille un tant soit peu importante. Or compte tenu, notamment, de la concentration urbaine et de la volonté de placer les zones aéroportuaires à des distances relativement faibles des zones urbaines, il devient de plus en plus nécessaire de maximiser le taux d'occupation des zones aéroportuaires en termes de surface. Par suite trouver une solution aux problèmes de réflexions parasites de signaux radioélectriques dans des directions sensibles apparaît plus que jamais actuel.

L'art antérieur connu en ce domaine nous apprend qu'il est théoriquement possible d'équiper les façades des bâtiments susceptibles d'être la cause fortuite de réflexions parasites dans des directions sensibles, de structures rapportées dont l'objet est de créer avec la paroi sur laquelle elles sont installées un dispositif diffracteur permettant de réfléchir les ondes incidentes, émises par des sources électromagnétiques extérieures, dans une direction privilégiée qui évite de générer des perturbations dans une zone sensible. Une telle structure est généralement constituée d'éléments structuraux longilignes, conducteurs, agencés de façon à former des nervures espacées les unes des autres. Les nervures sont généralement des éléments tubulaires présentant une épaisseur déterminée de façon à créer un déphasage de valeur donnée entre l'onde directement réfléchie par la paroi du bâtiment et celle réfléchie par les nervures. On forme ainsi un réseau diffracteur de type réseau de Bragg qui permet selon le déphasage induit par les nervures de diffracter l'onde incidente dans une direction voulue.

En fonction de la longueur d'onde $\lambda$ dont on cherche à empêcher la réflexion dans une direction donnée, les nervures qui constituent le revêtement ont une épaisseur h donnée qui peut, dans le cas où l'onde en question a une fréquence de l'ordre de la centaine de mégahertz être relativement importante. De tels éléments s'avèrent par conséquent difficiles, de par leur encombrement, à mettre en place sur la surface d'une façade, surtout si l'installation des éléments se fait après la construction du bâtiment.

Par ailleurs, pour assurer une diffraction correcte de l'onde incidente, il est généralement préférable d'équiper la façade exposée au rayonnement dont on veut empêcher les effets, de nervure présentant une longueur sensiblement égale à la hauteur ou occupant une portion significative de la partie supérieur de la façade. Par suite la fixation de ses éléments structuraux sur la façade considérée induit une charge importante sur la façade, charge que l'on cherche à minimiser en utilisant des éléments structuraux creux ayant une forme de tube. Cependant, de tels éléments restent des objets fragiles, dont le manque de rigidité intrinsèque reste généralement le point faible.

Ainsi, les types de revêtements bien connus de l'art antérieur utilisent des éléments structuraux dont le montage sur la façade à équiper est relativement délicat en termes de taille, ou plus exactement d'encombrement, de poids, poids supporté par la façade, et de rigidité de la structure formée.

Le fascicule du brevet US 3,538,663 décrit une structure de revêtement légère pour habiller des façades de bâtiments, par ailleurs planes de façon à leur donner un certain relief. Ladite structure est constituée d'éléments longilignes, chaque élément ayant une section en forme générale sensiblement en U ou en V et incorporant dans sa paroi un matériau isolant. Les éléments formant la structure sont montés sur la façade de façon à ce que leurs ouvertures soient dirigées vers ladite façade. Par ailleurs la disposition sur la façade des différents éléments formant la structure est définie de façon à procurer à l'ensemble une certaine esthétique.

Le fascicule de la demande de brevet Allemand DE 10 2008 059 018 décrit quant à lui une structure de revêtement de façade permettant d'assurer une réflexion diffuse des ondes électromagnétiques frappant ladite façade. Cette structure consiste en un arrangement chaotique en deux dimensions d'éléments réflecteurs formant des facettes de formes et de tailles diverses à la surface de la façade. La structure ainsi obtenue ne présente aucun ordre apparent de sorte qu'une onde électromagnétique incidente donne lieu à une pluralité d'ondes réfléchies qui en se combinant forment une onde réfléchie diffuse.

Le fascicule du brevet US 5,057,842 décrit également une structure de revêtement de façade permettant d'assurer une atténuation au moins partielle de l'onde électromagnétique réfléchie par la façade lorsque celle-ci reçoit une onde électromagnétique incidente. La structure est constituée d'un bâti sur lequel sont juxtaposées selon deux directions perpendiculaires des surfaces réfléchissantes selon un arrangement alterné à deux dimensions. Les surfaces réfléchissantes sont agencées vis-à-vis de la surface de la façade de telle façon que deux surfaces adjacentes selon l'une ou l'autre dimension sont disposées dans deux plans décalés l'un de l'autre vis-à-vis de la surface de la façade d'une distance donnée. Cet arrangement en quinconce d'éléments réfléchissants permet d'atténuer la réflexion de l'onde incidente.

Finalement, le fascicule de la demande de brevet japonais JP 2011109414 A divulgue une structure de revêtement pour les parois d'un cabinet de dossiers.

Un but de l'invention est de proposer une structure alternative pour former un réseau diffracteur de type réseau de Bragg. Cette structure est composée d'éléments structuraux tubulaires présentant à la fois, pour la bande de fréquence considérée, une rigidité intrinsèque supérieure à celle d'éléments de section rectangulaire, pour une épaisseur et une largeur sensiblement plus faibles que celles des éléments formant les structures connues.

A cet effet l'invention a pour objet l'utilisation d'un dispositif diffracteur selon la revendication indépendante 1.

Selon une forme de mise en œuvre particulière du dispositif, le pas d'espacement des différents éléments conducteurs est déterminé en fonction de la longueur d'onde $\lambda$ et de l'angle d'incidence $\theta$ de façon à créer un réseau de diffraction, de type réseau de Bragg, réalisant un déphasage de l'onde incidente tel que celle-ci soit diffractée dans une direction préférentielle.

Selon l'invention, si la source de l'émission électromagnétique est lointaine l'espacement entre les différents éléments conducteurs est constant le long de la paroi.

En revanche, si la source de l'émission électromagnétique est proche l'espacement entre les différents éléments conducteurs est fonction de l'angle d'incidence local de l'onde électromagnétique.

Selon l'invention, chaque élément résonant est constitué par un tube en matériau conducteur dont la paroi, qui définit une cavité interne, présente une ouverture longitudinale. Les dimensions et la géométrie de la cavité définie par la paroi, ainsi que la largeur de l'ouverture longitudinale pratiquée dans cette paroi, sont définies de façon à ce que l'élément se comporte d'un point de vue électromagnétique comme une résonateur LC de fréquence de résonance $F_0$ et de bande passante $\Delta F_0$.

Selon l'invention également, chaque élément résonant est préférentiellement configuré pour présenter un encombrement qui s'inscrit dans un volume parallélépipédique de dimensions données définies en tenant compte de contraintes mécaniques.

Selon l'invention, les éléments résonants formant le dispositif peuvent présenter des sections de formes polygonales diverses qui s'inscrivent toutes dans un rectangle, les éléments résonants présentant, en fonction de la section adoptée, des valeurs de capacité ou d'inductance particulières.

Dans une forme de réalisation particulière, la paroi d'un élément résonant présente en coupe transversale la forme d'un rectangle dont une longueur présente une discontinuité limitée par deux segments sensiblement perpendiculaires à ladite longueur dont les extrémités sont dirigées vers l'intérieur du périmètre.

Selon l'invention également, chaque élément résonnant peut être configuré de façon à former une pluralité de cavités tubulaires mitoyennes.

Dans une forme de réalisation particulière, chaque élément résonant est lui-même constitué d'une pluralité d'éléments résonants juxtaposés, dont les parois latérales sont en contact électrique.

Dans une forme de réalisation particulière, le volume interne des éléments résonants est vide.

Alternativement, dans une autre forme de réalisation, la cavité définie par la paroi de l'élément résonant est remplie d'un matériau diélectrique choisi de façon à renforcer la rigidité de l'élément.

Selon une variante de cette forme de réalisation, la cavité définie par la paroi de l'élément résonant est remplie de deux couches superposées de matériau diélectrique, une lame conductrice étant disposée dans la cavité, à l'interface entre les deux couches, en regard de la fente longitudinale formée le long de la paroi.

Alternativement, dans une autre forme de réalisation, la cavité définie par la paroi de l'élément résonant est remplie d'un matériau ferromagnétique non conducteur choisi de façon à augmenter la bande passante $\Delta F_0$ et diminuer la fréquence $F_0$ de la cavité résonante.

Alternativement encore, dans une autre forme de réalisation, la cavité définie par la paroi de l'élément résonant est remplie d'un matériau diélectrique de forte permittivité électrique $\varepsilon$, choisi de façon à diminuer la fréquence $F_0$ de la

cavité résonante.

Les caractéristiques et avantages de l'invention seront mieux appréciés grâce à la description qui suit, description qui s'appuie sur les figures annexées qui présentent:

- la figure 1, une représentation schématique d'ensemble du dispositif utilisé par l'invention;
- la figure 2, un schéma équivalent du fonctionnement d'un élément structural constituant le dispositif utilisé par l'invention;
- les figures 3 à 8, des illustrations de différentes variantes de réalisation du dispositif utilisé par l'invention ;
- la figure 9, une illustration mettant en évidence le caractère avantageux en termes de dimensions du dispositif utilisé par l'invention ;
- la figure 10, une courbe illustrant les avantages procurés par l'utilisation du dispositif selon l'invention.

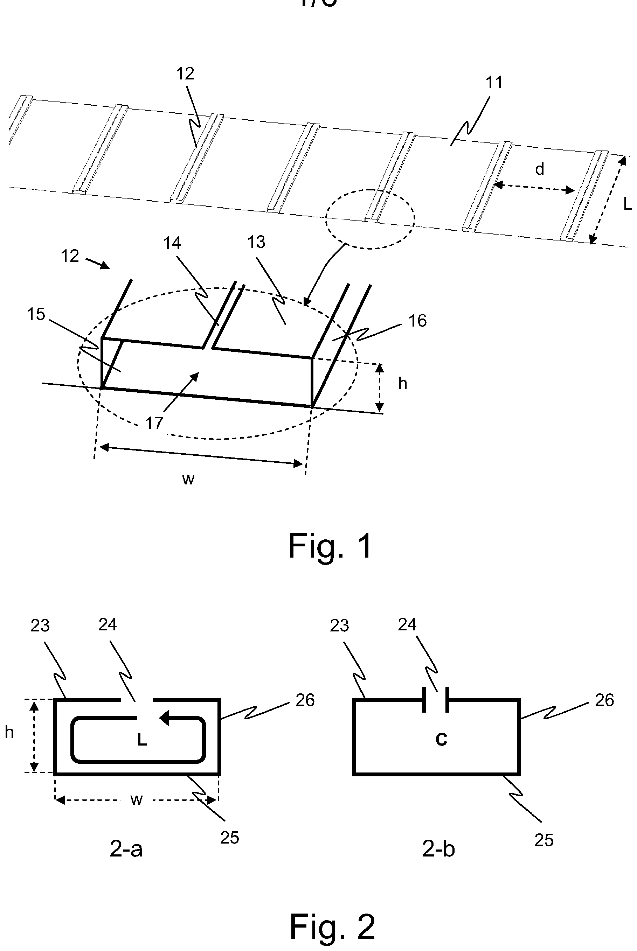

Les figures 1 et 2 permettent de présenter la structure générale du dispositif utilisé par l'invention. Comme l'illustre la figure 1, le revêtement selon l'invention se présente comme un arrangement d'éléments structuraux longilignes parallèles 12 dont la longueur dépend des dimensions de la paroi 11 à revêtir.

Les éléments structuraux 12 sont agencés sur la paroi 11 de façon à former un réseau de diffraction présentant un pas d. Selon l'invention, le pas d'espacement d des différents éléments conducteurs est classiquement déterminé en fonction de la longueur d'onde $\lambda$ et de l'angle d'incidence $\theta$ de façon à créer un réseau de diffraction réalisant un déphasage de l'onde incidente tel que celle-ci soit diffractée dans une direction préférentielle. Selon que la source de l'émission radioélectrique reçue par la paroi est considérée comme une source lointaine ou non, le pas d est un pas constant, comme sur la figure 1, ou un pas qui varie en fonction de l'angle d'incidence local de l'onde électromagnétique.

Les éléments structuraux 12 sont par ailleurs agencés sur la paroi 11 de façon à être orientés dans une direction sensiblement perpendiculaire au plan défini par les vecteurs de propagation des ondes incidente et réfléchie. Ainsi, dans le cas précis d'une façade de bâtiment les éléments structuraux sont disposés verticalement.

Selon l'invention, chaque élément structural 12 est un élément conducteur de la forme d'un cylindre creux, un tube, de forme polygonale, présentant une face plane 15 par laquelle il est fixé sur la paroi 11, la paroi du tube étant pourvue, sur la face opposée 13, d'une fente longitudinale 14 de largeur e donnée. Les éléments structuraux 12 sont réalisés dans un matériau conducteur, de sorte qu'ils forment des circuits L-C (i. e. inductance - capacité) à constantes L et C réparties. L'inductance L est formée par la paroi du tube elle-même et est fonction de l'aire délimitée par la paroi du tube, tandis que la capacité C est formée par la fente 14 ainsi que par la cavité 21.

Les dimensions de la paroi du tube sont par ailleurs déterminées de façon à ce que les valeurs de l'inductance L et de la capacité C permettent de réaliser un circuit équivalent résonant ayant une fréquence de résonance $F_0$ et une bande passante $\Delta F_0$ définies de manière connue par les relations suivantes :

$$F_0 \propto \frac{1}{\sqrt{L \cdot C}} \qquad\qquad [1]$$

et

$$\Delta F_0 \propto \sqrt{\frac{L}{C}} \qquad\qquad [2]$$

Du point de vue fonctionnement, chaque élément résonant, est configuré, dimensionné, de telle façon que lorsqu'il est éclairé par une onde radioélectrique incidente, il produise une onde radioélectrique de même fréquence mais affectée d'un déphasage donné, de sorte que la combinaison des ondes réfléchies par les différents éléments structuraux 12 et des ondes directement réfléchies par les portions de la paroi 11 situées entre ces éléments structuraux forme une onde diffractée dans la direction désirée.

Le dispositif selon l'invention se comporte donc comme un réseau de diffraction classique de type réseau de Bragg, comportant des éléments structuraux simplement conducteurs. En revanche d'un point de vue dimensionnel, les éléments structuraux qui le constituent permettent de réaliser un revêtement avantageusement plus facile à implanter sur une paroi, en particulier sur une façade de bâtiment.

En effet à la différence de celles des éléments conducteurs qui constituent un réseau de diffraction classique, les dimensions des éléments résonants qui constituent le dispositif selon l'invention ne sont pas directement fonction de la différence de marche à créer entre les ondes réfléchies par la paroi 11 elle-même et celles réfléchies par les éléments structuraux pour obtenir la diffraction désirée, mais par les valeurs de capacité et d'inductance que l'on désire obtenir.

Par suite pour un même résultat, c'est-à-dire pour un même déphasage entre les ondes réfléchies par la paroi 11 elle-même et celles réfléchies par les éléments structuraux, les dimensions de l'élément résonant sont sensiblement plus faibles que celles d'un simple élément conducteur.

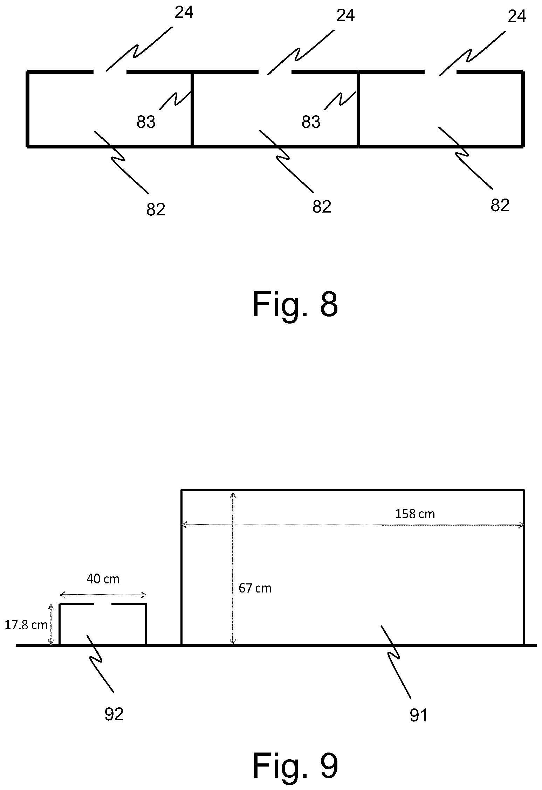

La figure 9 illustre cet avantage structurel en présentant les dimensions respectives des éléments structuraux constituant deux réseaux de diffraction destinés à contrôler l'onde réfléchie par une paroi éclairée sous une incidence d'environ 25° par une onde radioélectrique d'une fréquence d'une centaine de mégahertz émise par une source lointaine, c'est-à-dire une source située à une distance de la paroi telle que l'onde reçue par la façade 10 du bâtiment est une onde plane (Zone de Fraunhofer). On considère dans les deux cas des réseaux formés d'éléments structuraux de section rectangulaire. Le premier réseau 91 est un réseau classique constitué d'éléments conducteurs simples, tandis que le second réseau 92 est un dispositif selon l'invention, constitué d'éléments résonants 12. Comme on peut le constater sur la figure, pour un même résultat, à savoir produire une onde déphasée, les dimensions d'un élément résonant 12 sont très sensiblement inférieures à celle d'un élément conducteur simple.

Cette caractéristique dimensionnelle présente un double avantage. Le premier avantage est de l'ordre ergonomique et consiste en ce que, lorsqu'il est monté sur une paroi, le dispositif diffracteur utilisé par l'invention apparaît comme moins proéminent et moins masquant, de sorte que si la paroi est une façade pourvue de fenêtres, la lumière extérieure pénètre plus facilement dans le bâtiment. Le second avantage est d'ordre mécanique et consiste en ce que, les éléments résonants étant de dimensions plus faibles, le problème de leur rigidité intrinsèque et de leur éventuelle déformation sous l'effet de leur poids propre se pose de manière sensiblement moins aiguë lorsqu'ils sont montés sur la paroi 11 à revêtir.

Dans le texte qui suit, on présente différentes variantes de réalisation des éléments résonants constituant le dispositif utilisé par l'invention, dans lesquelles les éléments structuraux présentent des sections de formes variées. Ces différentes variantes de réalisation sont exposées ici dans le but de mettre en évidence que, pour un encombrement global donné, il est possible d'obtenir des éléments résonants ayant des fréquences de résonance $F_0$ et des bandes passantes $\Delta F_0$ différentes.

Pour bien mettre en évidence les avantages comparés des différentes variantes, on considère ici des éléments structuraux dont les sections forment des quadrilatères qui s'inscrivent dans un même rectangle de longueur w et de largeur h données. Il est à noter que les variantes de réalisation décrites ci-après ne limitent en rien la forme, l'objet ou la portée de l'invention.

Selon une première variante de réalisation simple, chaque tube présente, comme l'illustre la figure 2 une section rectangulaire avec deux grands cotés opposés 23 et 25 rectilignes, de longueur w, correspondant respectivement à la face interne 15 et à la face externe 13, et deux petits côtés 26, de longueur h, correspondant aux faces latérales 16. Par ailleurs, le côté 13 présente une discontinuité 24 correspondant à la fente 14. Dans cette variante de réalisation, la valeur de l'inductance L est notamment déterminée par l'aire décrite par la paroi du tube. La valeur de la capacité C est quant à elle déterminée par la largeur de la fente 14 correspondant sur la vue en coupe à la discontinuité 24 et les dimensions de l'espace interne délimité par la paroi de l'élément (cf. illustration 2-b).

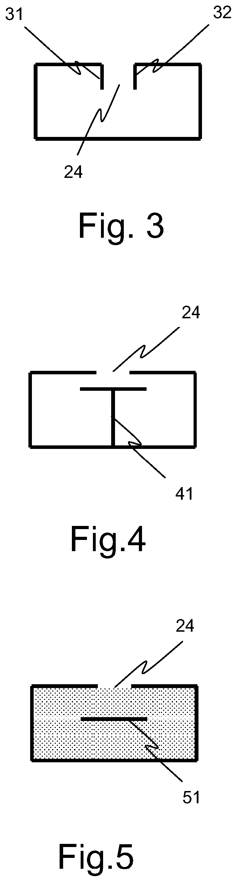

Selon une seconde variante de réalisation, chaque élément résonant présente une section telle que celle illustrée par la figure 3, dans laquelle la paroi de l'élément 12 présente le long de la fente 14, correspondant à la discontinuité 24 au niveau de la section, deux bords incurvés à 90° et se faisant face, représentés par deux segments de longueurs identiques 31 et 32. Ces deux bords ont des longueurs définies de façon à accroître la valeur de la capacité C par rapport à celle présentée par la variante précédente, et à rendre cette capacité C moins dépendante de la taille de la cavité (condensateur plan).

Selon une troisième variante de réalisation, illustrée par la figure 4, les éléments résonants 12 utilisés présentent en coupe une section rectangulaire dont une des longueurs présente une discontinuité 24 correspondant à la fente 14. Cependant, la cavité 17, définie par la paroi de l'élément résonant 11, loge un prolongement interne 41, solidaire de la face de la paroi 15 opposée à la paroi 13 comportant la fente 14, et formant une nervure 41 saillante à l'intérieur de la cavité.

Dans cette variante de réalisation, cette nervure 41 a, en coupe transversale, une forme de "T", dont la barre est parallèle aux longueurs 23 et 25 du rectangle représentant la section de l'élément. Elle est configurée et agencée à l'intérieur de la cavité de façon à ce que la barre du "T" se trouve placée en regard de la discontinuité 24, à une distance défini en fonction de la fréquence de résonance $F_0$ et de la largeur de bande $\Delta F_0$ attendues. Une telle configuration permet avantageusement d'accroître sensiblement la valeur de la capacité C sans modifier sensiblement la valeur de l'inductance L.

Selon une quatrième variante de réalisation, illustrée par la figure 5, la cavité des éléments résonants 12 utilisés ne contient pas simplement de l'air ambiant, mais est remplie d'un matériau diélectrique 51 dont le rôle essentiel est ici de renforcer la rigidité mécanique de l'élément. Une telle variante est particulièrement avantageuse si l'élément utilisé est de grande longueur, compte tenu des dimensions de la paroi à revêtir.

Il est à noter que dans cette variante de réalisation le matériau logé dans la cavité peut avoir, en outre, des propriétés électromagnétiques diverses. On peut ainsi, en utilisant un matériau présentant une forte permittivité $\varepsilon_r$, accroître la valeur de la capacité C, sans changer les dimensions de la cavité ni la forme de la paroi. Inversement, en utilisant un matériau présentant une forte perméabilité $\mu_r$, on peut accroître la valeur de l'inductance L sans rien changer d'autre.

Il est également à noter que cette variante de réalisation peut être associée à toutes les variantes précédentes. Elle peut en particulier inclure la mise en place dans le matériau d'une lame longitudinale 52 agencée de façon à se trouver en regard de la fente 14. On obtient ainsi un élément rayonnant très voisin dans sa définition de l'élément de la quatrième variante de réalisation décrite précédemment.

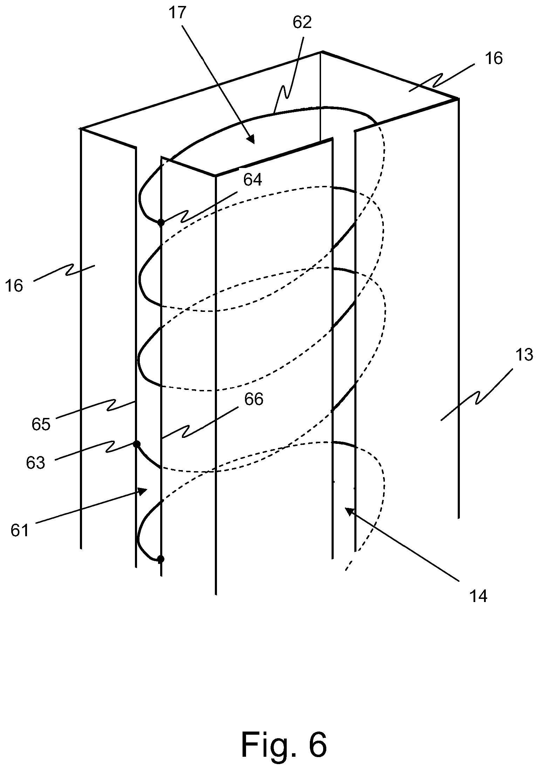

Selon une cinquième variante de réalisation, illustrée par la figure 6, une fente 61 est ménagée sur une des faces latérales 16 du résonateur, l'ensemble étant maintenu par une structure mécanique diélectrique appropriée, non représentée pour des raisons de clarté sur la figure. Un élément 62 présentant une forte self inductance est par ailleurs placé à l'intérieur de la cavité 17, et est relié électriquement par chacune de ses extrémités 63 et 64 aux deux bords 65 et 66 de la fente 61. Ainsi on augment l'inductance du circuit LC ce qui a pour effet de baisser sa fréquence de résonance $F_0$ et d'augmenter sa larguer de bande $\Delta F_0$.

Du point de vue de la réalisation, l'élément 62 peut être constitué d'un seul ensemble s'étendant sur toute la longueur de la cavité 17 ou bien, comme illustré par la figure 6, de plusieurs éléments agencés l'un à la suite de l'autre chaque élément étant relié par ses extrémités aux bords de la fente 61.

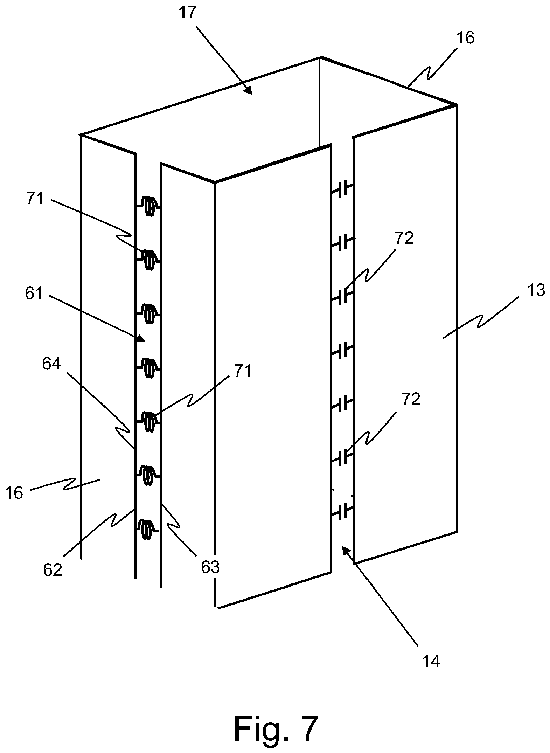

Selon une sixième variante de réalisation, illustrée par la figure 7, chaque élément résonant comporte une fente 61 est ménagée sur une des faces latérales 16 du résonateur ainsi que des inductances discrètes 71, réparties de préférence sur toute la longueur de la fente et dont les bornes relient chacune les deux bords 65 et 66 de la fente 61. Comme précédemment un tel arrangement permet d'augmenter l'inductance du circuit LC ce qui a pour effet de baisser sa fréquence de résonance $f_0$ et d'augmenter sa larguer de bande $\Delta f_0$. Par ailleurs, de manière optionnelle, chaque élément résonant peut comporter des éléments capacitifs discrets 72 implantés, de préférence, tout au long de la fente14 et dont les bornes sont reliées aux bords de cette fente.

Selon une septième variante de réalisation, illustrée par la figure 8, chaque élément résonant constituant le dispositif utilisé par l'invention est constitué de deux ou plusieurs éléments résonants élémentaires 11 tels que ceux décrits précédemment. Chaque élément résonant élémentaire est configuré de façon à présenter une fréquence de résonance $F_0$ et une bande passante $\Delta F_0$ données, $F_0$ et $\Delta F_0$ étant généralement les mêmes pour l'ensemble des éléments résonants associés.

Un tel agencement d'éléments résonants contigus accordés sur une même fréquence $F_0$ a pour avantage notable d'accroître la puissance re-rayonnée par l'élément résonant, sachant que, de manière connue, la valeur de la puissance re-rayonnée dépend principalement des dimensions (en particulier de la largeur w) de la face de l'élément résonant qui porte la fente 14. Ainsi en juxtaposant deux ou plusieurs éléments résonants élémentaires on augment sensiblement la puissance réémise par le dispositif, sans changer de manière notable les paramètres de fonctionnement du circuit résonant lui-même.

Dans une forme de réalisation simple, illustrée par la figure 8, les éléments composites ainsi constitués peuvent être réalisés à partir d'une seule structure tubulaire 81 de section rectangulaire dont la cavité interne est séparée en cavités élémentaires 82 par des cloisons intermédiaires 83, chaque cavité élémentaire 82 étant pourvue d'une fente longitudinale matérialisée sur la vue en coupe de la figure 7 par les discontinuités 84.

Ainsi comme on peut le constater au travers des formes de réalisation décrites dans le texte qui précède, le dispositif utilisé par l'invention propose pour réaliser le revêtement d'une paroi soumise à une émission radioélectrique dont on veut éviter la réflexion dans une direction donnée, une solution alternative avantageuse à l'utilisation de réseaux de diffraction à simples éléments structuraux conducteurs de l'art antérieur, aussi bien en ce qui concerne la mise en place que le fonctionnement.

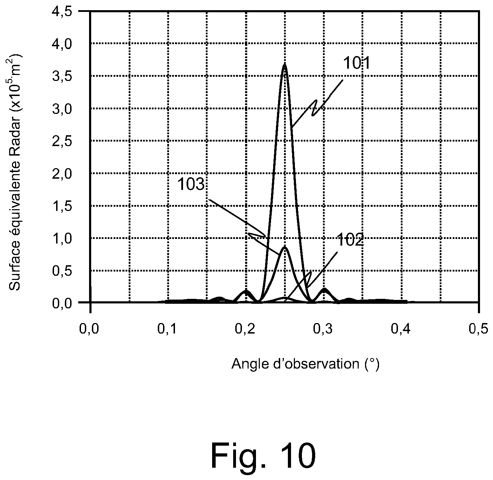

La figure 10 présente sur un même repère (angle d'observation, Surface équivalente de la paroi) les courbes de Surface Equivalente Radar d'une paroi constituée par la façade d'un bâtiment considérant trois états; un premier état (courbe 101) correspondant à une paroi nue, un deuxième état (courbe 102) correspondant à une paroi revêtue d'un réseau de diffraction selon l'art antérieur et un troisième état (courbe 103) correspondant à une paroi revêtue du dispositif selon l'invention. Ainsi qu'on peut le constater sur la figure, bien qu'étant moins efficace que les dispositifs de l'art antérieur (courbe 102) le dispositif selon l'invention permet de diminuer de manière très importante la surface équivalente de la paroi. Par suite il permet de réduire de manière suffisante le niveau des nuisances occasionnées par la réflexion d'ondes radioélectriques indésirables, tout en présentant avantageusement un encombrement bien inférieur à celui présenté par les dispositifs selon l'art antérieur, ce qui le rend en particulier moins massif et plus facile à installer.

**Revendications**

1. Utilisation d'un dispositif diffracteur pour équiper une façade (11) d'un bâtiment, susceptible d'être exposée à un rayonnement électromagnétique émis par une source située à distance du bâtiment, le dispositif comportant une pluralité d'éléments résonants tubulaires (12) disposés sur la façade dudit bâtiment (11), ces éléments résonants étant disposés de façon sensiblement parallèle sur la façade (11) dudit bâtiment, de façon à former un réseau diffracteur, et orientés dans une direction sensiblement perpendiculaire au plan défini par les vecteurs de propagation des ondes électromagnétiques incidente et réfléchie, chaque élément résonant (12) étant constitué par un tube en matériau conducteur de forme polygonale dont la paroi, qui définit une cavité interne (17), présente une ouverture longitudinale (14) sur une face (13) opposée à une face plane (15) par laquelle l'élément conducteur (12) est fixé à la façade (11), les dimensions et la géométrie de la cavité (17) définie par la paroi, ainsi que la largeur de l'ouverture longitudinale (14) pratiquée dans cette paroi, étant définies de façon à ce que l'élément (12) se comporte d'un point de vue électromagnétique comme un résonateur de type « LC » de fréquence de résonance $F_0$ et de bande passante $\Delta F_0$ apte à re-rayonner une onde correspondant à l'onde incidente affectée d'un déphasage, l'ensemble des éléments résonants étant agencé de telle façon que l'onde incidente soit diffractée dans une direction préférentielle.

2. Utilisation d'un dispositif diffracteur selon la revendication 1, **caractérisé en ce que** le pas d'espacement d des différents éléments conducteurs (12) est déterminé en fonction de la longueur d'onde $\lambda$ et de l'angle d'incidence $\theta$ de façon à créer un réseau de Bragg réalisant un déphasage de l'onde incidente tel que celle-ci soit diffractée dans une direction préférentielle.

3. Utilisation d'un dispositif diffracteur selon l'une des revendications 1 ou 2, **caractérisé en ce que**, si la source de l'émission électromagnétique est lointaine, l'espacement d entre les différents éléments conducteurs (12) est constant.

4. Dispositif selon l'une quelconque des revendications 1 ou 2, **caractérisé en ce que**, si la source de l'émission électromagnétique est proche, l'espacement d entre les différents éléments conducteurs est fonction de l'angle d'incidence local de l'onde électromagnétique.

5. Utilisation d'un dispositif diffracteur selon l'une quelconque des revendications 1 à 4, **caractérisé en ce que** chaque élément résonant (12) est configuré pour présenter un encombrement qui s'inscrit dans un volume parallélépipédique de dimensions données définies en tenant compte de contraintes mécaniques.

6. Utilisation d'un dispositif diffracteur selon la revendication 5, **caractérisé en ce que** la paroi d'un élément résonant (12) présente en coupe transversale la forme d'un rectangle dont une des longueurs présente une discontinuité (24) qui correspond à la fente longitudinale (14) formée le long de la paroi.

7. Utilisation d'un dispositif diffracteur selon la revendication 6, **caractérisé en ce que** la cavité (17) définie par la paroi de l'élément résonant (12) loge un prolongement interne (51) solidaire de la face interne de ladite paroi et formant une nervure ayant en coupe transversale une forme de "T", dont la barre est parallèle aux longueurs du rectangle, la nervure (51) étant configurée et agencée à l'intérieur de la cavité (17) de façon à ce que la barre du "T" se trouve placée en regard de l'ouverture (24) présentée par l'une des longueurs du rectangle, à une distance définie en fonction de la fréquence $F_0$ et de la largeur de bande $\Delta F_0$.

8. Utilisation d'un dispositif diffracteur selon la revendication 5, **caractérisé en ce que** la paroi d'un élément résonant (12) présente en coupe transversale la forme d'un rectangle dont une longueur présente une discontinuité limitée par deux segments (31, 32) sensiblement perpendiculaires à ladite longueur dont les extrémités sont dirigées vers l'intérieur du périmètre.

9. Utilisation d'un dispositif diffracteur selon l'une quelconque des revendications précédentes, **caractérisé en ce que** les cavités (17) définies par les parois des éléments résonants sont remplies d'un matériau diélectrique (51) choisi de façon à renforcer la rigidité des éléments.

10. Utilisation d'un dispositif diffracteur selon l'une quelconque des revendications précédentes, **caractérisé en ce que** les cavités (17) définies par les parois des éléments résonants (12) sont remplies de deux couches superposées d'un matériau diélectrique choisi de façon à renforcer la rigidité des éléments, une lame conductrice (52) étant disposée dans chaque cavité (17) à l'interface entre les deux couches, en regard de la fente longitudinale (14) formée le long de la paroi.

11. Utilisation d'un dispositif diffracteur selon l'une quelconque des revendications précédentes, **caractérisé en ce que** les cavités (17) définies par les parois des éléments résonants (12) sont remplies d'un matériau ferromagnétique non conducteur choisi de façon à augmenter la bande passante $\Delta F_0$ et diminuer la fréquence $F_0$ de ces éléments.

**12.** Utilisation d'un dispositif diffracteur selon l'une quelconque des revendications précédentes, **caractérisé en ce que** les cavités (17) définies par les parois des éléments résonants (12) sont remplies d'un matériau diélectrique de forte permittivité électrique ε, choisi de façon à diminuer la fréquence de résonance $F_0$ des éléments.

**Patentansprüche**

**1.** Verwendung einer Beugungsvorrichtung zur Ausstattung einer Fassade (11) eines Gebäudes, die einer elektromagnetischen Strahlung ausgesetzt sein kann, die von einer Quelle emittiert wird, die sich in Abstand zum Gebäude befindet, wobei die Vorrichtung eine Vielzahl von rohrförmigen Resonanzelementen (12) aufweist, die auf der Fassade des Gebäudes (11) angeordnet sind, wobei diese Resonanzelemente im Wesentlichen parallel auf der Fassade (11) des Gebäudes angeordnet sind, um ein Beugungsgitter zu bilden, und in einer Richtung im Wesentlichen lotrecht zu der von den Ausbreitungsvektoren der einfallenden und reflektierten elektromagnetischen Wellen definierten Ebene ausgerichtet sind, wobei jedes Resonanzelement (12) aus einem Rohr aus leitendem Material polygonaler Form besteht, dessen Wand, die einen inneren Hohlraum (17) definiert, eine Längsöffnung (14) auf einer Seite (13) aufweist, die einer ebenen Seite (15) gegenüberliegt, durch die das leitende Element (12) an der Fassade (11) befestigt ist, wobei die Abmessungen und die Geometrie des von der Wand definierten Hohlraums (17) sowie die Breite der in dieser Wand ausgeführten Längsöffnung (14) so definiert sind, dass das Element (12) sich aus elektromagnetischer Sicht wie ein Resonator des Typs "LC" mit einer Resonanzfrequenz $F_0$ und einem Durchlassband $\Delta F_0$ verhält, der eine Welle erneut ausstrahlen kann, die der von einer Phasenverschiebung beeinflussten einfallenden Welle entspricht, wobei die Gesamtheit der Resonanzelemente so eingerichtet ist, dass die einfallende Welle in einer bevorzugten Richtung gebeugt wird.

**2.** Verwendung einer Beugungsvorrichtung nach Anspruch 1, **dadurch gekennzeichnet, dass** die Abstandteilung d der verschiedenen leitenden Elemente (12) abhängig von der Wellenlänge λ und vom Einfallswinkel θ so bestimmt wird, dass ein Bragg-Gitter erzeugt wird, das eine derartige Phasenverschiebung der einfallenden Welle herstellt, dass diese in einer bevorzugten Richtung gebeugt wird.

**3.** Verwendung einer Beugungsvorrichtung nach einem der Ansprüche 1 oder 2, **dadurch gekennzeichnet, dass**, wenn die Quelle der elektromagnetischen Emission fern ist, der Abstand d zwischen den verschiedenen leitenden Elementen (12) konstant ist.

**4.** Vorrichtung nach einem der Ansprüche 1 oder 2, **dadurch gekennzeichnet, dass**, wenn die Quelle der elektromagnetischen Emission nahe ist, der Abstand d zwischen den verschiedenen leitenden Elementen vom lokalen Einfallswinkel der elektromagnetischen Welle abhängt.

**5.** Verwendung einer Beugungsvorrichtung nach einem der Ansprüche 1 bis 4, **dadurch gekennzeichnet, dass** jedes Resonanzelement (12) konfiguriert ist, einen Platzbedarf aufzuweisen, der in einem parallelepipedischen Volumen gegebener Abmessungen liegt, die unter Berücksichtigung mechanischer Erfordernisse definiert werden.

**6.** Verwendung einer Beugungsvorrichtung nach Anspruch 5, **dadurch gekennzeichnet, dass** die Wand eines Resonanzelements (12) im Querschnitt die Form eines Rechtecks aufweist, von dem eine der Längen eine Unterbrechung (24) aufweist, die dem entlang der Wand geformten Längsschlitz (14) entspricht.

**7.** Verwendung einer Beugungsvorrichtung nach Anspruch 6, **dadurch gekennzeichnet, dass** der von der Wand des Resonanzelements (12) definierte Hohlraum (17) eine innere Verlängerung (51) aufnimmt, die fest mit der Innenseite der Wand verbunden ist und eine Rippe bildet, die im Querschnitt die Form eines "T" hat, dessen Querstrich parallel zu den Längen des Rechtecks ist, wobei die Rippe (51) so konfiguriert und im Inneren des Hohlraums (17) angeordnet ist, dass der Querstrich des "T" sich gegenüber der Öffnung (24) befindet, die eine der Längen des Rechtecks aufweist, in einem abhängig von der Frequenz $F_0$ und von der Bandbreite $\Delta F_0$ definierten Abstand.

**8.** Verwendung einer Beugungsvorrichtung nach Anspruch 5, **dadurch gekennzeichnet, dass** die Wand eines Resonanzelements (12) im Querschnitt die Form eines Rechtecks aufweist, von dem eine Länge eine von zwei im Wesentlichen zur Länge lotrechten Segmenten (31, 32) begrenzte Unterbrechung aufweist, deren Enden zum Inneren des Umfangs gerichtet sind.

**9.** Verwendung einer Beugungsvorrichtung nach einem der vorhergehenden Ansprüche, **dadurch gekennzeichnet, dass** die von den Wänden der Resonanzelemente definierten Hohlräume (17) mit einem dielektrischen Material (51) gefüllt sind, das so gewählt wird, dass es die Steifigkeit der Elemente verstärkt.

10. Verwendung einer Beugungsvorrichtung nach einem der vorhergehenden Ansprüche, **dadurch gekennzeichnet, dass** die von den Wänden der Resonanzelemente (12) definierten Hohlräume (17) mit zwei übereinander liegenden Schichten eines dielektrischen Materials gefüllt sind, das so gewählt wird, dass es die Steifigkeit der Elemente verstärkt, wobei eine leitende Lamelle (52) in jedem Hohlraum (17) an der Schnittstelle zwischen den zwei Schichten gegenüber dem entlang der Wand gebildeten Längsschlitz (14) angeordnet ist.

11. Verwendung einer Beugungsvorrichtung nach einem der vorhergehenden Ansprüche, **dadurch gekennzeichnet, dass** die von den Wänden der Resonanzelemente (12) definierten Hohlräume (17) mit einem nicht leitenden ferromagnetischen Material gefüllt sind, das so gewählt wird, dass es das Durchlassband $\Delta F_0$ vergrößert und die Frequenz $F_0$ dieser Elemente verringert.

12. Verwendung einer Beugungsvorrichtung nach einem der vorhergehenden Ansprüche, **dadurch gekennzeichnet, dass** die von den Wänden der Resonanzelemente (12) definierten Hohlräume (17) mit einem dielektrischen Material hoher elektrischer Permittivität $\varepsilon$ gefüllt sind, das so gewählt wird, dass es die Resonanzfrequenz $F_0$ der Elemente verringert.

## Claims

1. Use of a diffracting device to equip a frontage (11) of a building, that can be exposed to an electromagnetic radiation emitted by a source situated at a distance from the building, the device comprising a plurality of tubular resonant elements (12) disposed on the frontage of said building (11), these resonant elements being disposed substantially parallel on the frontage (11) of said building, so as to form a diffraction grating, and oriented in a direction substantially at right angles to the plane defined by the vectors of propagation of the incident and reflected electromagnetic waves, each resonant element (12) consisting of a pipe made of conductive material of polygonal form whose wall, which defines an internal cavity (17), has a longitudinal aperture (14) on a face (13) opposite a planar face (15) by which the conductive element (12) is fixed to the frontage (11), the dimensions and the geometry of the cavity (17) defined by the wall, and the width of the longitudinal aperture (14) formed in this wall, being defined so that the element (12) behaves, from an electromagnetic point of view, as a resonant of "LC" type of resonant frequency $F_0$ and of bandwidth $\Delta F_0$ capable of re-radiating a wave corresponding to the incident wave affected by a phase-shift, all of the resonant elements being arranged so that the incident wave is diffracted in a preferential direction.

2. Use of a diffracting device according to Claim 1, **characterized in that** the spacing pitch d of the different conductive elements (12) is determined as a function of the wavelength $\lambda$ and of the angle of incidence $\theta$ so as to create a Bragg grating producing a phase-shifting of the incident wave such that the latter is diffracted in a preferential direction.

3. Use of a diffracting device according to one of Claims 1 and 2, **characterized in that**, if the source of the electromagnetic emission is distant, the spacing d between the different conductive elements (12) is constant.

4. Device according to either one of Claims 1 and 2, **characterized in that**, if the source of the electromagnetic emission is close, the spacing d between the different conductive elements is a function of the local angle of incidence of the electromagnetic wave.

5. Use of a diffracting device according to any one of Claims 1 to 4, **characterized in that** each resonant element (12) is configured to have a bulk which lies within a parallelepipedal volume of given dimensions defined by taking account of mechanical constraints.

6. Use of a diffracting device according to Claim 5, **characterized in that** the wall of a resonant element (12) has, in transverse cross-section, the form of a rectangle in which one of the lengths has a discontinuity (24) which corresponds to the longitudinal slit (14) formed along the wall.

7. Use of a diffracting device according to Claim 6, **characterized in that** the cavity (17) defined by the wall of the resonant element (12) houses an internal extension (51) secured to the internal face of said wall and forming a rib having, in transverse cross-section, a "T" form, the bar of which is parallel to the lengths of the rectangle, the rib (51) being configured and arranged inside the cavity (17) so that the bar of the "T" is placed facing the aperture (24) offered by one of the lengths of the rectangle, at a defined distance as a function of the frequency $F_0$ and of the

bandwidth $\Delta F_0$.

8. Use of a diffracting device according to Claim 5, **characterized in that** the wall of a resonant element (12) has, in transverse cross-section, the form of a rectangle in which a length has a discontinuity limited by two segments (31, 32) substantially at right angles to said length, the ends of which are directed towards the interior of the perimeter.

9. Use of a diffracting device according to any one of the preceding claims, **characterized in that** the cavities (17) defined by the walls of the resonant elements are filled with a dielectric material (51) chosen so as to reinforce the rigidity of the elements.

10. Use of a diffracting device according to any one of the preceding claims, **characterized in that** the cavities (17) defined by the walls of the resonant elements (12) are filled with two superposed layers of a dielectric material chosen so as to reinforce the rigidity of the elements, a conductive blade (52) being disposed in each cavity (17) at the interface between the two layers, facing the longitudinal slit (14) formed along the wall.

11. Use of a diffracting device according to any one of the preceding claims, **characterized in that** the cavities (17) defined by the walls of the resonant elements (12) are filled with a non-conductive ferromagnetic material chosen so as to increase the bandwidth $\Delta F_0$ and reduce the frequency $F_0$ of these elements.

12. Use of a diffracting device according to any one of the preceding claims, **characterized in that** the cavities (17) defined by the walls of the resonant elements (12) are filled with a dielectric material of high electrical permittivity $\varepsilon$ chosen so as to reduce the resonant frequency $F_0$ of the elements.

1/8

**Fig. 1**

2-a

2-b

**Fig. 2**

31    32

24

Fig. 3

24

41

Fig.4

24

51

Fig.5

Fig. 6

Fig. 7

24           24           24

83          83

82          82          82

# Fig. 8

40 cm

158 cm

17.8 cm     67 cm

92          91

# Fig. 9

Fig. 10

## RÉFÉRENCES CITÉES DANS LA DESCRIPTION

**Documents brevets cités dans la description**

- US 3538663 A
- DE 102008059018
- US 5057842 A
- JP 2011109414 A